# FASCICULE DE BREVET EUROPEEN

(11) **EP 1 399 880 B1**
(45) Date de publication et mention de la délivrance du brevet: **18.01.2006**
(21) Numéro de dépôt: 02748948.3
(22) Date de dépôt: 12.06.2002
(51) Int. Cl.: G06K 19/077

(54) **CARTE A PUCE SANS CONTACT AVEC UN SUPPORT D'ANTENNE ET UN SUPPORT DE PUCE EN MATERIAU FIBREUX**
KONTAKTLOSE CHIPKARTE MIT EINEM ANTENNENTRÄGER UND EINEM CHIPTRÄGER AUS FASERMATERIAL
CONTACTLESS CHIPCARD WITH AN ANTENNA SUPPORT AND CHIP SUPPORT MADE FROM A FIBROUS MATERIAL

(30) Priorité: 14.06.2001 FR 0107782
(43) Date de publication de la demande: 24.03.2004
(73) Titulaire: ASK S.A., 06560 Sophia Antipolis (FR)
(72) Inventeur: KAYANAKIS, Georges, 06600 Antibes (FR)
(86) Numéro de dépôt international: PCT/FR2002/002006
(87) Numéro de publication internationale: WO 2002/103628

(56) Documents cités:
- DE-A- 19 929 912
- FR-A- 2 764 414
- FR-A- 2 778 308
- FR-A- 2 801 707

## Description

### Domaine technique

La présente invention concerne le domaine des cartes à puce et plus particulièrement une carte à puce sans contact comprenant un adaptateur en papier.

### Etat de la technique

Le secteur de la carte à puce est en pleine expansion. Ces outils qui se sont démocratisés sous la forme des cartes bancaires et des cartes de téléphone, ont subi un second essor considérable avec le développement de nouvelles technologies et notamment l'avènement du sans contact. En effet, de nouvelles applications ont vu le jour. Ainsi, dans le secteur des transports, la carte sans contact a été développée comme moyen de paiement que ce soit au niveau des transports en commun ou sur les axes autoroutiers. Le porte-monnaie électronique est une autre application des cartes à puce sans contact comme moyen de paiement. De nombreuses sociétés ont également développé des moyens d'identification de leur personnel par cartes à puce sans contact.

L'échange d'informations entre une carte sans contact et le dispositif de lecture associé s'effectue par couplage électromagnétique à distance entre une antenne logée dans la carte sans contact et une deuxième antenne située dans le lecteur. Pour élaborer, stocker et traiter les informations, la carte est munie d'une puce ou d'un module électronique sans contact qui est relié(e) à l'antenne. L'antenne et la puce ou le module sans contact se trouvent généralement sur un support diélectrique en matière plastique (polychlorure de vinyle (PVC), polyester (PET), polycarbonate (PC)...). L'antenne est obtenue par gravure chimique du cuivre ou de l'aluminium sur le support ou bobinage d'un fil de métal conducteur tel que du cuivre.

La carte est souvent monobloc. En effet, le support d'antenne est inséré entre deux couches en matière plastique (PVC, PET, PC, acrylonitrile-butadiène-styrène (ABS)...) constituant les corps de carte supérieur et inférieur et thermosoudées par lamination sous pression à chaud. La puce ou le module sans contact est connecté à l'antenne par une colle conductrice ou équivalent qui permet d'établir le contact ohmique.

Toutefois, une carte de ce type possède plusieurs inconvénients majeurs. L'inconvénient le plus important est que la thermosoudure plastique, mise en oeuvre au moment de la lamination, conduit à une carte monobloc dont les propriétés mécaniques sont médiocres en terme de restitution des contraintes absorbées. Lorsque des contraintes excessives de torsion et/ou flexion sont appliquées, la totalité de la contrainte imposée est transmise à la puce ou module sans contact et plus particulièrement aux points de colle assurant les connexions. La tenue mécanique des joints de colle est soumise à rude épreuve et cela peut se traduire par une rupture de la connexion puce - antenne ou module sans contact - antenne. L'antenne peut également être coupée du fait de ces contraintes mécaniques.

Un autre inconvénient des cartes à puce sans contact classiques est leur coût de revient. En effet, l'utilisation d'une antenne obtenue par gravure chimique ou bobinage d'un fil de métal est à l'origine de coût de revient élevé qui est peu compatible avec une diffusion importante de ce genre d'outil. De même, l'utilisation d'un module électronique sans contact augmente ce coût de revient.

Pour remédier à ces inconvénients, un autre procédé de fabrication, décrit dans le brevet français FR-A-2 801 708 consiste à utiliser un support en matière fibreuse tel que du papier sur lequel est réalisée l'antenne par sérigraphie d'encre conductrice. Le support d'antenne subit alors un traitement thermique afin de cuire l'encre. Les étapes suivantes consistent à connecter la puce et l'antenne et à souder de chaque côté du support d'antenne les corps de carte sur le support d'antenne par pressage à chaud, cette dernière étape étant l'étape de lamination.

L'inconvénient de ce procédé réside dans le fait que la rigidité de la puce dont les plots de contact sont collés sur les plots de contact de l'antenne afin d'établir la connexion, crée des fissures de l'encre conductrice formant l'antenne lors de l'étape de lamination. Par conséquent, la connexion entre la puce et l'antenne est parfois rompue, dans tous les cas elle est fragilisée, et peut se rompre à tout moment et en particulier lors de contraintes externes.

### Exposé de l'invention

Un premier but de l'invention est donc de pallier ces inconvénients en fournissant une carte à puce sans contact qui soit peu sensible aux contraintes mécaniques liées à son utilisation et dont le coût de revient soit faible grâce à l'usage de matériaux peu coûteux.

Un deuxième but de l'invention est de fournir une carte à puce sans contact dont les connexions entre l'antenne et la puce ne soient pas fragilisés lors de l'étape de lamination de la carte.

L'invention concerne donc une carte à puce sans contact comprenant une antenne sur un support d'antenne en matériau fibreux, l'antenne étant constituée d'au moins une spire d'encre conductrice et de deux plots de connexion sérigraphiés sur le support d'antenne, deux corps de carte de chaque côté du support d'antenne, chacun des corps de carte étant constitué d'au moins une couche de matière plastique, et une puce, munie de plots de connexions, connectée à l'antenne. Cette carte comprend également un support de puce en matériau fibreux comportant deux bandes d'encre conductrice polymérisable, sérigraphiées sur le support de puce, sur auxquelles sont connectés les plots de connexion de la puce, le support de puce étant positionné sur le support d'antenne de manière à ce que les bandes d'encre conductrice polymérisable entrent en contact avec des plots de connexion de l'antenne et se connectent à ces derniers, et de manière à ce que la puce vienne se positionner dans une cavité aménagée à cet effet dans le support d'antenne afin qu'aucun élément rigide de la puce ne soit en contact avec les plots de connexion de l'antenne ou avec l'antenne. Un autre objet de l'invention est un procédé de fabrication d'une carte à puce, comprenant les étapes suivantes :
- fabrication d'une antenne consistant à sérigraphier des spires d'encre conductrice polymérisable et deux plots de connexion de l'antenne sur un support d'antenne en matériau fibreux et à faire subir à ce support d'antenne un traitement thermique de façon à cuire et polymériser l'encre conductrice,
- aménagement d'une cavité dans le support d'antenne par découpe de ce dernier,
- fabrication d'un support de puce en matériaux fibreux par sérigraphie de deux bandes d'encre conductrice polymérisable sur un support en matériau fibreux,
- connexion d'une puce, munie de plots de connexion sur le support de puce, de manière à ce que les plots de connexion de la puce soient en contact avec les bandes d'encre conductrice polymérisable,
- positionnement du support de puce sur le support d'antenne de manière à ce que les bandes d'encre conductrice polymérisable soient en contact avec les plots de connexion de l'antenne et à ce que la puce se retrouve dans la cavité, et
- lamination de corps de carte de chaque côté du support d'antenne, consistant à souder de chaque côté du support au moins une couche de matière plastique par pressage à chaud.

### Description brève des figures

Les buts, objets et caractéristiques ressortiront mieux à la lecture de la description qui suit faite en référence aux dessins joints dans lesquels :
La figure 1 représente une vue de face du support d'antenne de la carte à puce selon l'invention.
Les figures 2a et 2b représentent une vue de face du support de puce de la carte à puce selon l'invention.
La figure 3 représente une vue en coupe selon l'axe A-A du support de puce représenté à la figure 2.
La figure 4 représente une vue en coupe longitudinale du support d'antenne portant le support de puce.
La figure 5 représente une vue en coupe longitudinale de la carte à puce selon l'invention.

### Description détaillée de l'invention

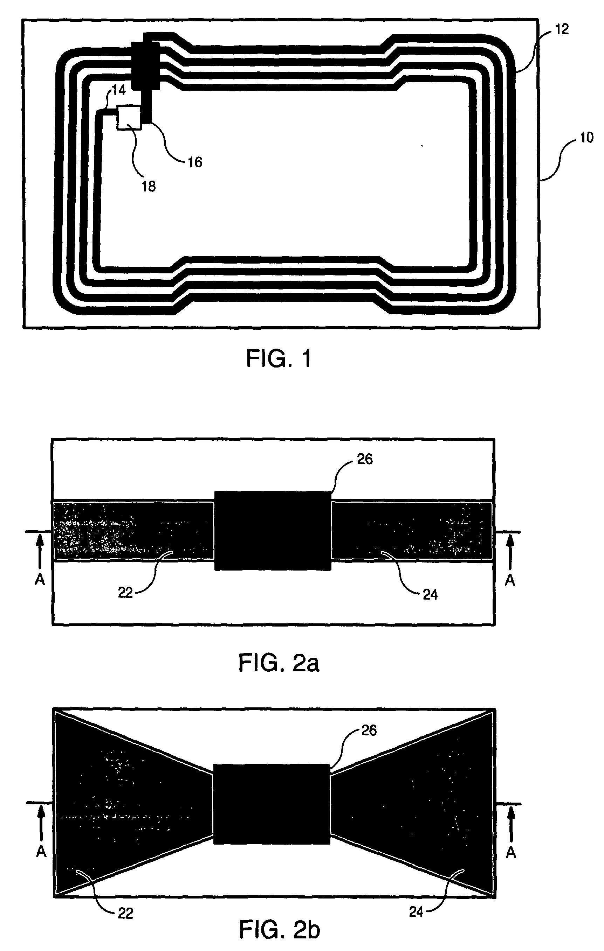

La carte à puce selon l'invention comprend un support d'antenne 10, tel que représenté à la figure 1. Ce support 10 est constitué par un matériau fibreux. Ce matériau est préférentiellement du papier. Sur ce support est sérigraphiée une antenne 12. Cette antenne est constituée de quatre spires concentriques. Chacune des extrémités de l'antenne 10 constitue un plot de connexion de l'antenne 14 ou 16. Les spires et les plots de connexion de l'antenne sont constitués d'une encre conductrice polymérisable. Selon un mode de réalisation préféré, cette encre est une encre époxy chargée en éléments conducteurs tels que l'argent, le cuivre ou le carbone. Une cavité 18 est aménagée dans le support d'antenne par découpe de ce dernier. Cette cavité a pour fonction de recevoir la puce.

Le support de puce 20 est représenté de face sur les figures 2a et 2b. Ce support 20 est constitué par un matériau fibreux. Selon un mode de réalisation préféré, ce matériau fibreux est du papier. Sur ce support 20, sont sérigraphiées deux bandes d'encre conductrice polymérisable 22 et 24. Selon un mode de réalisation préféré, cette encre est une encre époxy chargée en éléments conducteurs tels que l'argent, le cuivre ou le carbone. La surface d'encre polymérisable 22 et 24 peut être d'une autre forme sans pour autant sortir du cadre de l'invention. Par exemple, les surfaces 22 et 24 peuvent être deux trapèzes dont les grands côtés sont juxtaposés avec les bords externes opposés du support 20 tel que représenté sur la figure 2b. La grande superficie de cette forme trapézoïdale diminue le degré de précision de l'opération qui consiste à poser le support de puce sur le support d'antenne afin d'établir la connection donc d'augmenter la vitesse de réalisation de cette opération et donc d'obtenir des rendements supérieurs et des coûts de machine moindre. Une puce 26 munie de deux plots de connexion est positionnée sur le support 20.

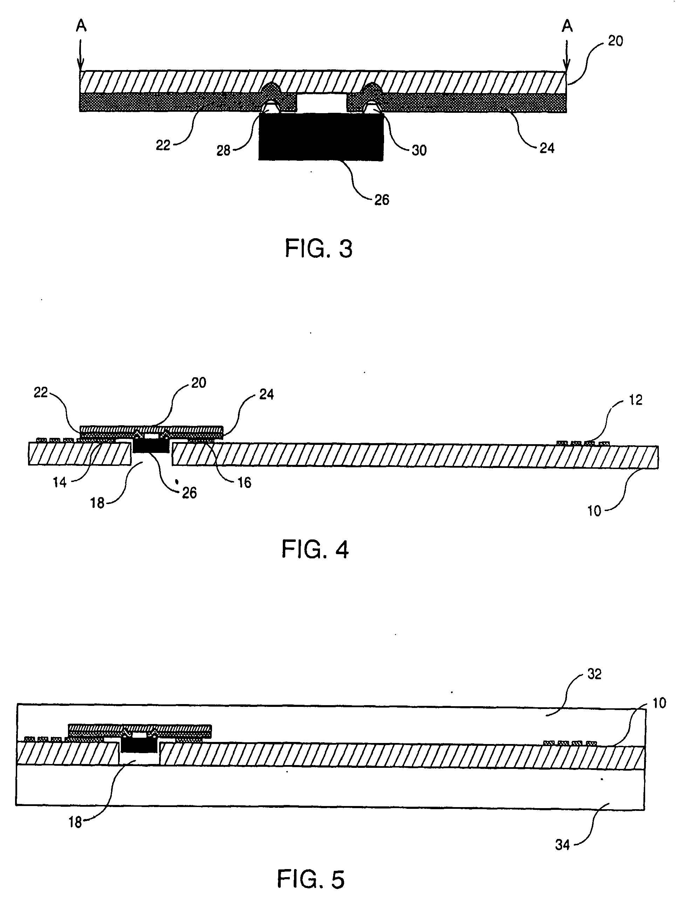

La figure 3 représente une coupe longitudinale du support de puce 20 représenté sur la figure 2, selon l'axe A-A. On observe que la puce 26 est connectée au support 20 de manière à ce que les plots de connexion 28 et 30 soient en contact avec les bandes d'encre conductrice polymérisable 22 et 24. Plusieurs méthodes peuvent être utilisées pour connecter la puce 26 sur le support 20.

Selon un premier mode de réalisation, une fois la puce 26 positionnée de telle façon que les plots de connexion 28 et 30 soient en regard des bandes d'encre conductrice 22 et 24, une pression est exercée sur la puce de façon à ce que ses plots de connexion déforment le support de puce 20 et les bandes d'encre conductrice polymérisable 22 et 24, sous l'effet de la pression. Le support de puce 20 et les bandes d'encre conductrice polymérisable 22 et 24 conservent alors leur déformation après que la pression a cessé d'être exercée, permettant ainsi d'obtenir une surface de contact importante entre les plots de connexion de la puce et les bandes d'encre conductrice.

Selon un second mode de réalisation, les bandes d'encre conductrice polymérisable 22 et 24 sont enduites d'une colle conductrice. Puis la puce 26 est positionnée sur le support de puce 20 de manière à ce que les plots de connexion 28 et 30 de ladite puce viennent baigner dans ladite colle conductrice, en regard des bandes d'encre conductrice polymérisable 22 et 24.

Le support de puce 20 ainsi obtenu est positionné sur le support d'antenne 10 de manière à ce que la puce 26 soit contenue dans la cavité 18, tel que représenté sur la figure 4. Les bandes d'encre conductrice polymérisable 22 et 24 entrent en contact avec les plots de connexion de l'antenne 14 et 16. La puce 26 est alors connectée à l'antenne 12. Lorsque la fabrication de la carte est terminée, cette connexion réalisée sans colle conductrice est définitive. La grande longueur des bandes d'encre conductrice polymérisable 22 et 24 autorise un éventuel déplacement longitudinal, du support de puce 20 sur le support d'antenne 10 sans affecter la connexion entre la puce et l'antenne. Un déplacement transversal n'étant pas possible une fois la carte fabriquée. Néanmoins, dans un souci de perfectionnement et afin d'améliorer le contact et d'empêcher le support de puce 20 de bouger, une couche de colle conductrice peut être appliquée entre les bandes d'encre conductrice polymérisable 22 et 24 et les plots de connexion de l'antenne 14 et 16.

La carte à puce dans sa configuration définitive est représentée en coupe longitudinale, sur la figure 5. Une couche de matière plastique a été laminée de chaque côté du support d'antenne 10, portant le support de puce 20, constituant ainsi les corps de carte 32 et 34. Cette lamination est préférentiellement réalisée par pressage à chaud. La matière plastique des corps de carte est du polychlorure de vinyle (PVC), du polyester (PET, PETG), du polycarbonate (PC) ou de l'acrylonitrile-butadiène-styrène (ABS). Selon un mode de réalisation préféré, ces corps de carte sont en PVC. Selon ce mode de réalisation, chaque corps de carte est constitué d'une seule couche. Toutefois, chaque corps de carte peut être constitué de plusieurs couches de matière plastique identique ou différente.

La carte à puce ainsi obtenue dispose d'une excellente tenue mécanique par le fait que le support d'antenne et le support de puce sont dans une même matière fibreuse très souple. Ainsi, contrairement aux cartes sans contact utilisant un module métallique, aucune contrainte mécanique n'est transmise au support d'antenne, risquant d'entraîner des coupures d'antenne. Le seul point de contrainte existant dans cette carte est la puce elle-même de par sa structure rigide. Toutefois, la surface de la puce étant très limitée, ces contraintes sont également limitées. De plus, la puce étant positionnée sur un support de puce spécifique et prenant place dans une cavité aménagée dans le support d'antenne, elle n'est pas en contact direct avec ce dernier donc elle n'est pas en contact avec les plots de connexion ou les spires de l'antenne, ce qui réduit d'autant les contraintes mécaniques et notamment les contraintes de cisaillement qui pourraient s'exercer sur les plots de connexion de l'antenne ou sur l'antenne elle-même au moment de l'étape de lamination. Cette carte à puce possède donc une grande fiabilité, et ceci malgré l'utilisation de matériaux peu coûteux, matériaux qui permettent d'obtenir une carte avec un très faible coût de revient.

## Revendications

1. Carte à puce sans contact comprenant une antenne (12) sur un support d'antenne (10) en matériau fibreux, ladite antenne étant constituée d'au moins une spire d'encre conductrice polymérisable et de deux plots de connexion (14 et 16) sérigraphiés sur ledit support d'antenne, un corps de carte (32, 34) de chaque côté dudit support d'antenne, lesdits corps de carte étant constitués d'au moins une couche de matière plastique, et une puce (26) munie de plots de connexions (28 et 30), connectée à ladite antenne,
ladite carte étant **caractérisée en ce qu'**elle comprend également un support de puce (20) en matériau fibreux comportant deux bandes d'encre conductrice polymérisable (22 et 24) sérigraphiées sur ledit support de puce (20), et auxquelles sont connectés lesdits plots de connexion (28 et 30) de la puce (26), ledit support de puce (20) étant positionné sur ledit support d'antenne (10) de manière à ce que lesdites bandes d'encre conductrice polymérisable (22 et 24) entrent en contact avec lesdits plots de connexion (14 et 16) de l'antenne et se connectent à ces derniers, et de manière à ce que ladite puce (26) vienne se positionner dans une cavité (18), aménagée à cet effet dans ledit support d'antenne (10) afin qu'aucun élément rigide de la puce ne soit en contact avec lesdits plots de connexion (14 et 16) de l'antenne ou ladite antenne (12).

2. Carte à puce selon la revendication 1, dans laquelle la connexion de la puce aux bandes d'encre conductrice polymérisable est obtenue par enfoncement desdits plots de connexion de la puce dans lesdites bandes d'encre conductrice et dans ledit support de puce.

3. Carte à puce selon la revendication 1, dans laquelle la connexion de la puce aux bandes d'encre conductrice polymérisable est obtenue par l'intermédiaire d'une couche de colle conductrice placée entre les plots de la puce et lesdites bandes d'encre conductrice polymérisable.

4. Carte à puce selon l'une des revendications précédentes, dans laquelle ledit matériau fibreux est du papier.

5. Carte à puce selon l'une des revendications précédentes, dans laquelle les bandes d'encre conductrice polymérisable sont connectées aux plots de connexion de l'antenne par l'intermédiaire d'une couche de colle conductrice.

6. Carte à puce selon l'une des revendications précédentes, dans laquelle la matière plastique constituant les corps de carte est du polychlorure de vinyle (PVC), du polyester (PET, PETG), du polycarbonate (PC) ou de l'acrylonitrile-butadiène-styrène (ABS).

7. Carte à puce selon l'une des revendications précédentes, dans laquelle ladite encre conductrice polymérisable est une encre époxy chargée en éléments conducteurs tels que des particules d'argent, de cuivre ou de carbone.

8. Procédé de fabrication d'une carte à puce selon l'une des revendication 1 à 7, comprenant les étapes suivantes :
- fabrication d'une antenne (12) consistant à sérigraphier des spires d'encre conductrice polymérisable et deux plots de connexion (14 et 16) de ladite antenne sur un support d'antenne (10) en matériau fibreux et à faire subir à ce support d'antenne un traitement thermique de façon à cuire et polymériser l'encre conductrice,
- aménagement d'une cavité (18) dans ledit support d'antenne (10) par découpe de ce dernier,
- fabrication d'un support de puce en matériau fibreux par sérigraphie de deux bandes d'encre conductrice polymérisable (22 et 24) sur un support en matériau fibreux (20),
- connexion d'une puce (26), munie de plots de connexion (28 et 30) sur ledit support de puce (20), de manière à ce que lesdits plots de connexion (28 et 30) soient en contact avec lesdites bandes d'encre conductrice polymérisable (22 et 24),
- positionnement du support de puce (20) sur le support d'antenne (10) de manière à ce que lesdites bandes d'encre conductrice polymérisable soient en contact avec lesdits plots de connexion (14 et 16) de l'antenne (12) et à ce que ladite puce (26) se retrouve dans la cavité (18) afin qu'aucun élément rigide de la puce ne soient en contact avec lesdits plots de connexion (14 et 16) de l'antenne ou ladite antenne (12), et
- lamination de corps de carte (32 et 34) de chaque côté dudit support d'antenne (10), consistant à souder de chaque côté dudit support au moins une couche de matière plastique par pressage à chaud et à connecter parfaitement ladite puce (26) avec l'antenne (12).

## Patentansprüche

1. Kontaktlose Chipkarte mit einer Antenne (12) auf einem Antennenträger (10) aus Fasermaterial, wobei die Antenne aus mindestens einer Windung einer polymerisierbaren leitenden Farbe und aus zwei Anschlussplättchen (14 und 16) besteht, die auf den Antennenträger mittels Siebdruck aufgebracht sind, mit einem Kartenkörper (32, 34) auf jeder Seite des Antennenträgers, wobei die Kartenkörper aus mindestens einer Schicht aus Kunststoffmaterial bestehen, und mit einem Chip (26), der mit Anschlussplättchen (28 und 30) versehen und an die Antenne angeschlossen ist,
wobei die Karte **dadurch gekennzeichnet ist, dass** sie ebenfalls einen Chipträger (20) aus Fasermaterial aufweist, der zwei Bänder aus polymerisierbarer leitender Farbe (22 und 24) besitzt, die mittels Siebdruck auf den Chipträger (20) aufgebracht sind und an die die Anschlussplättchen (28 und 30) des Chips (26) angeschlossen sind, wobei der Chipträger (20) derart auf dem Antennenträger (10) positioniert ist, dass die Bänder aus polymerisierbarer leitender Farbe (22 und 24) mit den Anschlussplättchen (14 und 16) der Antenne in Kontakt kommen und sich an diese anschließen, und derart, dass der Chip (26) in einem Hohlraum (18) positioniert wird, der zu diesem Zweck im Antennenträger (10) ausgebildet ist, damit kein steifes Element des Chips mit den Anschlussplättchen (14 und 16) der Antenne oder der Antenne (12) in Kontakt ist.

2. Chipkarte nach Anspruch 1, bei der der Anschluss des Chips an die Bänder aus polymerisierbarer leitender Farbe durch Eindrücken der Anschlussplättchen des Chips in die Bänder aus leitender Farbe und in den Chipträger erhalten wird.

3. Chipkarte nach Anspruch 1, bei der der Anschluss des Chips an die Bänder aus polymerisierbarer leitender Farbe mittels einer leitenden Klebstoffschicht erhalten wird, die zwischen den Plättchen des Chips und den Bändern aus polymerisierbarer leitender Farbe angeordnet ist.

4. Chipkarte nach einem der vorhergehenden Ansprüche, bei der das Fasermaterial Papier ist.

5. Chipkarte nach einem der vorhergehenden Ansprüche, bei der die Bänder aus polymerisierbarer leitender Farbe mittels einer leitenden Klebstoffschicht an die Anschlussplättchen der Antenne angeschlossen werden.

6. Chipkarte nach einem der vorhergehenden Ansprüche, bei der das die Kartenkörper bildende Kunststoffmaterial Polyvinylchlorid (PVC), Polyester (PET, PETG), Polycarbonat (PC) oder Acrylnitril-Butadien-Styrol (ABS) ist.

7. Chipkarte nach einem der vorhergehenden Ansprüche, bei der die polymerisierbare leitende Farbe eine Epoxy-Farbe ist, die mit leitenden Elementen wie Silber-, Kupfer- oder Kohlenstoffpartikeln angereichert ist.

8. Verfahren zur Herstellung einer Chipkarte nach einem der Ansprüche 1 bis 7, das die folgenden Schritte aufweist:
- Herstellen einer Antenne (12), das darin besteht, Windungen einer polymerisierbaren leitenden Farbe und zwei Anschlussplättchen (14 und 16) der Antenne mittels Siebdruck auf einen Antennenträger (10) aus Fasermaterial aufzubringen und diesen Antennenträger einer Wärmebehandlung zu unterziehen, um die leitende Farbe einzubrennen und zu polymerisieren,
- Ausbilden eines Hohlraums (18) im Antennenträger (10) durch Ausschneiden des letzteren,
- Herstellen eines Chipträgers aus Fasermaterial durch Siebdruck von zwei Bändern einer polymerisierbaren leitenden Farbe (22 und 24) auf einen Träger aus Fasermaterial (20),
- Anschluss eines mit Anschlussplättchen (28 und 30) versehenen Chips (26) an den Chipträger (20) derart, dass die Anschlussplättchen (28 und 30) mit den Bändern aus polymerisierbarer leitender Farbe (22 und 24) in Kontakt sind,
- Positionieren des Chipträgers (20) auf dem Antennenträger (10) derart, dass die Bänder aus polymerisierbarer leitender Farbe mit den Anschlussplättchen (14 und 16) der Antenne (12) in Kontakt sind, und dass der Chip (26) sich im Hohlraum (18) befindet, damit kein steifes Element des Chips mit den Anschlussplättchen (14 und 16) der Antenne oder der Antenne (12) in Kontakt ist, und
- Laminieren von Kartenkörpern (32 und 34) auf beiden Seiten des Antennenträgers (10), das darin besteht, auf jeder Seite des Trägers mindestens eine Schicht aus Kunststoffmaterial durch Warmpressen anzuschweißen und den Chip (26) perfekt an die Antenne (12) anzuschließen.

## Claims

1. A contactless smart card featuring an antenna (12) on an antenna support (10) made of fibrous material, said antenna consisting of at least one turn of conductive ink and two contacts (14 and 16) which are screen printed on said antenna support, one card body (32, 34) on each side of said antenna support, said card bodies being made up of at least one layer of plastic material, and a chip (26) provided with contacts (28 and 30) connected to said antenna,
said card being **characterized in that** it also includes a chip support (20) made of fibrous materials including two strips of polymerizable conductive ink (22 and 24) screen printed on said chip support (20), and to which are connected said contacts (28 and 30) of the chip (26), said chip support (20) being positioned on said antenna support (10) in such a manner that said strips of polymerizable conductive ink (22 and 24) come into contact with said antenna contacts (14 and 16) and connect to the latter, and in such a manner that said chip (26) is positioned in a cavity (18), provided to that end in said antenna support (10) so that no rigid element of the chip comes into contact with said antenna contacts (14 and 16) or said antenna (12).

2. The smart card according to claim 1, in which the chip's connection to the strips of polymerizable conductive ink is made by burying said chip contacts in said strips of conductive ink and in said chip support.

3. The smart card according to claim 1, in which the chip's connection to the strips of polymerizable conductive ink is obtained through a layer of conductive glue placed between the chip's contacts and said strips of polymerizable conductive ink.

4. The smart card according to any one of the previous claims in which said fibrous material is paper.

5. The smart card according to any one of the previous claims in which said strips of polymerizable conductive ink are connected to the antenna contacts by means of a layer of conductive glue.

6. The smart card according to any of the previous claims, in which the plastic material forming the card bodies is polyvinyl chloride (PVC), polyester (PET, PETG), polycarbonate (PC) or acrylonitrile-butadienestyrene (ABS).

7. Smart card according to any of the previous claims in which said polymerizable, conductive ink is an epoxy ink doped with conductive elements such as particles of silver, copper or carbon.

8. A smart card manufacturing method according to any one of claims 1 to 7, including the steps of:
- manufacturing an antenna (12) consisting in screen printing turns printed using polymerizable conductive ink and two contacts (14 and 16) of said antenna on an antenna support (10) made of fibrous material and to subject this antenna support to heat treatment so as to bake and polymerize the conductive ink,
- creating a cavity (18) in said antenna support (10) by a cutout in the latter,
- manufacturing a chip support made of fibrous material by screen printing two strips of polymerizable conductive ink (22 and 24) on a support made of fibrous material (20),
- connecting a chip (26), featuring contacts (28 and 30) on said chip support (20), such that said contacts (28 and 30) are in contact with said strips of polymerizable conductive ink (22 and 24),
- positioning the chip support (20) on the antenna support (10) so that said strips of polymerizable conductive ink are in contact with said contacts (14 and 16) of the antenna (12) and so that said chip (26) is placed in the cavity (18) so that no rigid element of the chip comes into contact with said antenna contacts (14 and 16) or said antenna (12), and
- laminating card bodies (32 and 34) on each side of said antenna support (10), consisting in welding at least one layer of plastic material on each side of said support by hot press molding and to perfectly connect said chip (26) with the antenna (12).
